# EUROPEAN PATENT APPLICATION

(11) **EP 4 550 519 A1**
(43) Date of publication of application: **07.05.2025**
(21) Application number: 24210164.0
(22) Date of filing: 31.10.2024
(51) Int. Cl.: H01M 10/42, H01M 10/613, H01M 10/6235, H01M 10/6551, H01M 10/6554, H01M 50/204, H01M 50/213, H01M 50/247, H01M 50/271, H01M 50/284, H01M 50/287

(54) **BATTERY PACK**

(30) Priority: 03.11.2023 CN 202311459149
(71) Applicant: Techtronic Floor Care Technology Limited, Tortola (VG)
(72) Inventor: DIANA, Patrick, Davidson North Carolina 28036 (US); KOZLOWSKI, William Jacob Jr., Monroe North Carolina 28132 (US); THOMPSON, Michael, Charlotte North Carolina 28262 (US); LEE, Hei Man, Kwai Chung Hong Kong (CN); XU, Dian Wu, Dongguan City Guangdong Province (CN); LIAO, Pei, Dongguan City Guangdong Province (CN); LV, Bo Rong, Dongguan City Guangdong Province (CN); ZENG, Kui, Dongguan City Guangdong Province (CN)
(74) Representative: Gray, James

(57) **Abstract**

A battery pack (10) for an electrical device including a housing (14) having a first housing portion (18) defining a first compartment (36) and a second housing portion (22) defining a second compartment (38), a plurality of battery cells (44) disposed within the first compartment and configured to supply power to the electrical device, a circuit board (48) disposed within the first compartment and including a heat generating component (50), and a heat sink (60) coupled to the second housing portion and disposed adjacent the heat generating component. The heat sink includes a first portion (68) extending toward the heat generating component and disposed within the first compartment, and a second portion (72) extending away from the heat generating component and disposed within the second compartment.

## Description

### CROSS-REFERENCE TO RELATED APPLICATIONS

This application claims priority to Chinese Patent Application No. 202311459149.1, filed November 3, 2023, the entire contents of which are hereby incorporated by reference herein.

### BACKGROUND

The present disclosure relates to battery packs, and more particularly, to heat sinks used in rechargeable battery packs.

Batteries may produce heat during charging and discharging as a result of the electrochemical reaction driving the battery and the current flowing through the electronic components. Excess heat can result in several complications, including thermal runaway. Batteries for electronic consumer devices may be particularly at risk of overheating due to the large currents drawn by the electronic consumer devices and the compact nature of the battery electronics and terminals.

### SUMMARY

In one embodiment, the disclosure provides a battery pack for an electrical device including a housing having a first housing portion defining a first compartment and a second housing portion defining a second compartment. The first housing portion is adjacent the second housing portion. The battery pack further includes at least one terminal configured to electrically connect the battery pack to the electrical device, a plurality of battery cells disposed within the first compartment and configured to supply power to the electrical device, a circuit board disposed within the first compartment and including a heat generating component, and a heat sink coupled to the second housing portion and disposed adjacent the heat generating component. The heat sink includes a first portion extending toward the heat generating component and disposed within the first compartment, and a second portion extending away from the heat generating component and disposed within the second compartment.

In another embodiment, the disclosure provides a battery pack for an electrical device including a housing having a first housing portion defining a first compartment and a second housing portion defining a second compartment. The first housing portion is adjacent the second housing portion. The battery pack further includes a plurality of battery cells disposed within the first compartment and configured to supply power to the electrical device, a circuit board disposed within the first compartment and including a heat generating component aligned with an aperture in the second housing portion, and a heat sink coupled to the second housing portion and covering the aperture, resulting in the second compartment being fluidly sealed from the first compartment. The battery pack further includes a first vent disposed on the second housing portion that allows ambient air surrounding the housing to enter the second compartment, creating an airflow path within the second compartment, and another vent in fluid communication with the second compartment and configured to allow the airflow path to exit the second compartment after passing over the heat sink.

In another embodiment, the disclosure provides a battery pack for an electrical device including a housing having a first compartment and a second compartment that is fluidly sealed from the first compartment. The battery pack further includes a plurality of battery cells disposed within the first compartment and configured to supply power to the electrical device, a circuit board disposed within the first compartment and including a heat generating component, and a heat sink coupled to the housing and is in direct contact with the heat generating component to dissipate heat away from the second compartment.

In another embodiment, the disclosure provides a battery pack for an electrical device including a housing and a plurality of battery cells disposed within the housing and configured to supply power to the electrical device. The plurality of battery cells are fluidly sealed from environment surrounding the housing. The battery pack further includes circuit board coupled to the plurality of battery cells and including a heat generating component. A heat sink is coupled to the housing and is in direct contact with the heat generating component to dissipate heat away from the plurality of battery cells to the environment.

Other aspects of the disclosure will become apparent by consideration of the detailed description and accompanying drawings.

### BRIEF DESCRIPTION OF THE DRAWINGS

Fig. 1 is a perspective view of a battery pack according to an embodiment of the application.
Fig. 2 is an exploded view of the battery pack of Fig. 1, illustrating a housing having a first housing portion and a second housing portion with a heat sink coupled to the second housing portion.
Fig. 3 is a cross-sectional view of the battery pack along line 3-3 of Fig. 1, illustrating the heat sink disposed adjacent a circuit board.
Fig. 4 is a cross-sectional view of the battery pack along line 4-4 of Fig. 1, illustrating an airflow path within the housing.
Fig. 5 is a cross-sectional view of a battery pack according to another embodiment of the application, illustrating a fan that forces an airflow path within the housing.
Fig. 6 is a cross-sectional view of a battery pack according to yet another embodiment of the application, illustrating a fan that forces an airflow path within the housing.

Before any embodiments are explained in detail, it is to be understood that the disclosure is not limited in its application to the details of construction and the arrangement of components set forth in the following description or illustrated in the following drawings. The disclosure is capable of other embodiments and of being practiced or of being carried out in various ways.

### DETAILED DESCRIPTION

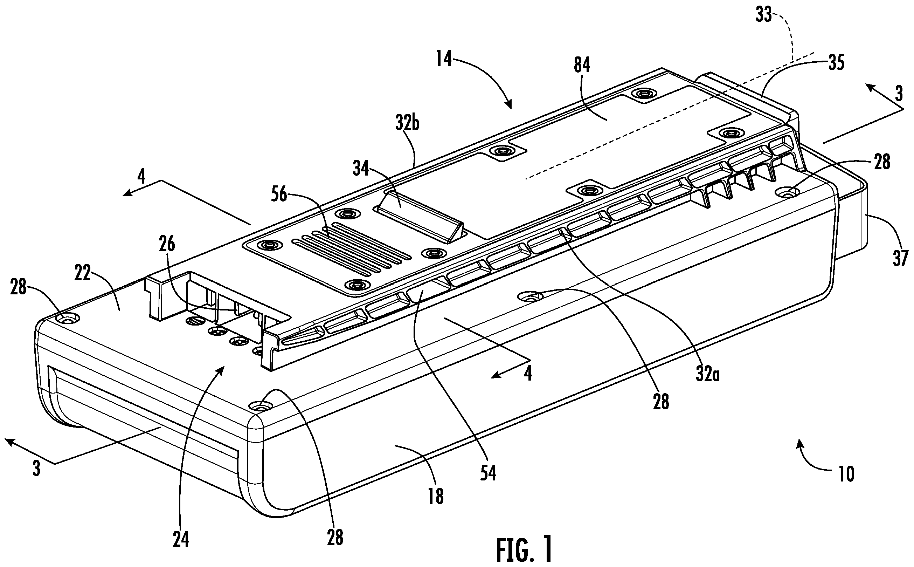

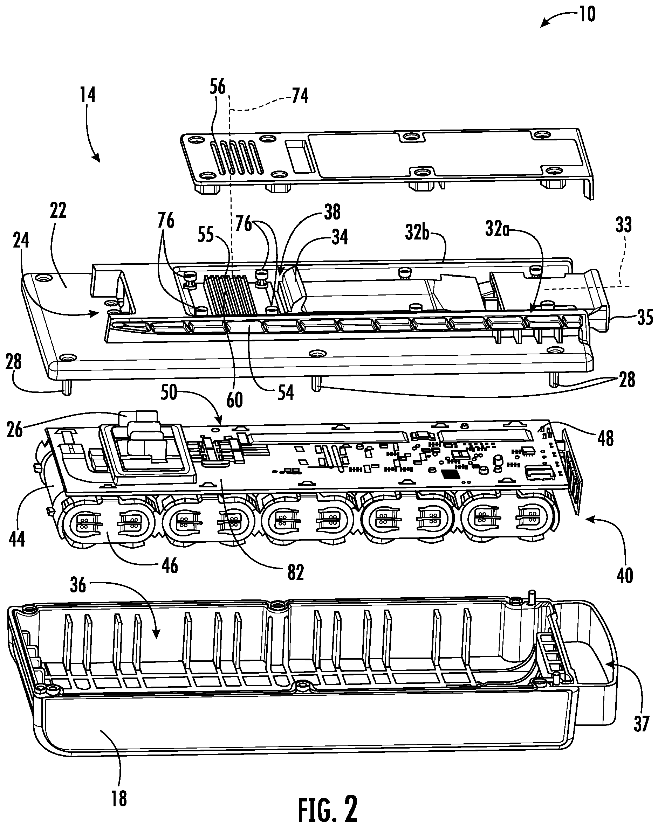

Figs. 1 and 2 illustrate a battery pack 10 according to one embodiment. The battery pack 10 is connectable and operable to electrical consumer devices, such as, hand-held power tools (e.g., vacuum cleaners, extractor vacuums, drill drivers). The battery pack 10 is removable from the electrical device and is rechargeable by a battery charger (not shown). The battery pack 10 includes a battery chemistry such as, lead-acid, Nickel-cadmium ("NiCd"), Nickel-Metal Hydride ("NiMH"), Lithium ("Li"), Lithium-ion ("Li-ion"), or other rechargeable or non-rechargeable battery chemistry. In some embodiments, the battery pack 10 may have a chemistry of Lithium Cobalt ("Li-Co"), Lithium Manganese ("Li-Mn") Spinel, Li-Mn Nickel, or other lithium metal chemistry.

In one embodiment, the battery pack 10 includes a nominal voltage of 40 V. In other embodiments, the battery pack 10 can have a nominal voltage, such as, 12 V, 18 V, 24 V, 80 V, or other voltage as desired to power the electrical device and be charged by the battery charger (not shown).

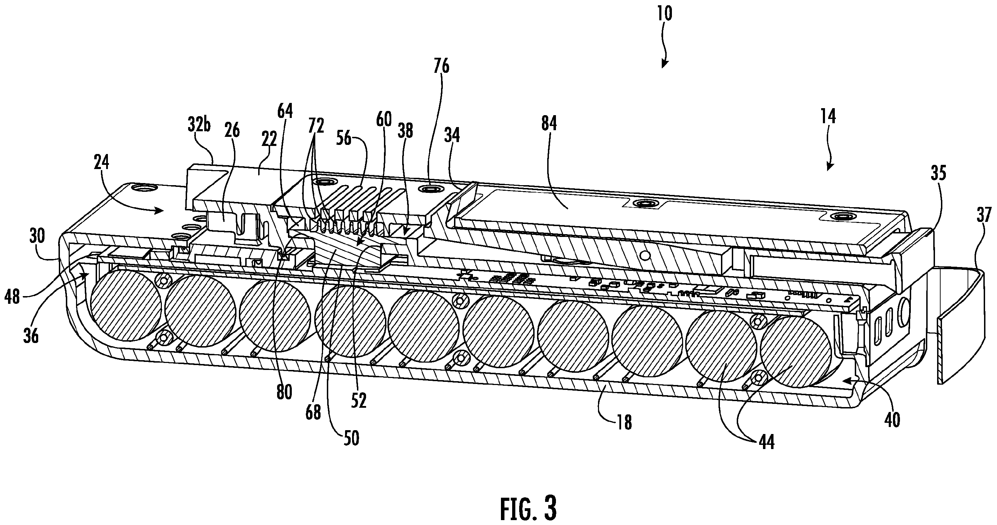

With continued reference to Figs. 1 and 2, the battery pack 10 includes a housing 14 having a first housing portion 18 and second housing portion 22. The first housing portion 18 and the second housing portion 22 are configured as a clamshell design, where the first housing portion 18 and the second housing portion 22 are coupled together. In other embodiments, there may be fewer or greater than two housing portions. For example, the first housing portion 18 and the second housing portion 22 may be integrally formed together. The battery pack 10 further includes an electrical interface 24 having one or more terminals 26 that are configured to interface and electrically connect to the electrical device or the battery charger. The terminals 26 are accessible from outside the housing 14 to allow the electrical device or the battery charger to directly engage the electrical interface 24. The first housing portion 18 and the second housing portion 22 are coupled together via a plurality of fasteners 28. In the illustrated embodiment, a tongue-and-groove joint 30 (FIG. 3) is disposed at the interface between the first housing portion 18 and the second housing portion 22 to inhibit ingress of liquid and debris from entering the housing 14. Specifically, the tongue-and-groove joint 30 extends around the periphery of the housing 14. Although fasteners 28 are used to couple the first and second housing portion 18, 22 together in the illustrated embodiment, in other embodiments, the first housing portion 18 and the second housing portion 22 may be coupled together via adhesives, tapes, tabs, or any combination thereof. The battery pack 10 further includes a first mounting rail 32a and a second mounting rail 32b that extend parallel to a slide axis 33 (Fig. 1) of the battery pack 10. The first and second mounting rails 32a, 32b are configured to interact with and couple the battery pack 10 to the electrical device or the battery charger in a direction along the slide axis 33. The first and second mounting rails 32a, 23b are disposed on the second housing portion 22. A locking mechanism 34 may be provided to lock the battery pack 10 to the electrical device. The locking mechanism 34 is actuatable to selectively permit removal of the battery pack 10 from the electrical device. In some embodiments, the locking mechanism 34 includes or is connected to a push button 35 that is actuatable such that a user may push the button 35 to disengage the locking mechanism 34 (e.g., a locking tab) and pull the battery pack 10 along slide axis 33 to remove the battery pack 10 from the electrical device. The push button 35 may be located adjacent to a handle 37 on the battery pack 10, as shown in FIG. 3.

With reference to Figs. 2 and 3, the housing 14 defines a first compartment 36 and a second compartment 38 that is separate from the first compartment 36. In the illustrated embodiment, the first compartment 36 is within the first housing portion 18 and the second compartment 38 is within the second housing portion 22. Specifically, the second compartment 38 is disposed between the first and second mounting rails 32a, 32b. The first compartment 36 of the housing 14 receives and supports a battery cell assembly 40. The battery cell assembly 40 includes a plurality of battery cells 44 and a support structure 46 that receives and supports the plurality of battery cells 44. The plurality of battery cells 44 include the chemistry and the nominal voltage as described above. In the illustrated embodiment, the plurality of battery cells 44 includes ten battery cells, while in other embodiments, the plurality of battery cells 44 may alternatively include a different number of predetermined battery cells (e.g., twenty, thirty, forty, one hundred) as desired and selected to provide the desired electrical characteristics (e.g., nominal voltage, current output, current capacity, power capacity) of the battery pack 10. The housing 14 is shaped and sized to receive the plurality of battery cells 44. The battery cells 44 can be connected in series, parallel, or combination series-parallel to provide the desired electrical characteristics (e.g., nominal voltage, current output, current capacity, power capacity) of the battery pack 10.

With reference to Fig. 3, the housing 14 substantially encloses a supporting circuit or circuit board 48 electrically connected to the one or more terminals 26. The circuit board 48 is disposed above and supported by the battery cell assembly 40, such that the circuit board 48 is located within the first compartment 36 of the first housing portion 18. In particular, the circuit board 48 is supported on top of the support structure 46 of the battery cell assembly 40 and adjacent the second housing portion 22. The circuit board 48 includes one or more heat generating electronic components 50 (e.g., MOSFETs, resistors, transistors, capacitors, inductors, sensors) that are aligned with a footprint of an aperture 52 in the second housing portion 22. The circuit board 48 also includes a microcontroller or microprocessor that is configured to provide operational control of the battery pack 10 and monitor various characteristics (e.g., voltage, temperature) of each individual battery cell 44. For example, the circuit board 48 controls the charging and discharging of the battery cells 44 and may initiate power supply to the electrical device via the battery cells 44. The circuit board 48 may also communicate with the electrical device and the battery charger (not shown), and may provide information to the devices regarding one or more battery characteristics or conditions of the battery pack 10, such as, the nominal voltage, the temperature, the chemistry, and/or other similar characteristics. To avoid inadvertent damage to the battery pack 10 from overheating, heat that is expelled from the heat generating electronic component 50 should be dissipated away from the battery pack 10.

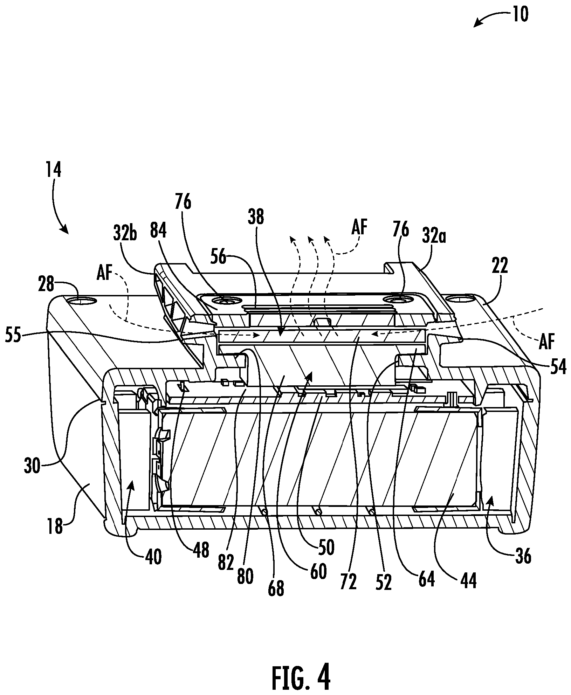

With reference to Figs. 1-4, the second housing portion 22 of the housing 14 also includes a first vent 54, a second vent 55, and a third vent 56, allowing an airflow path AF (Fig. 4) to pass through the second compartment 38 of the housing 14. Although heat is generated by components (e.g., the battery cells 44, the circuit board 48) in the first compartment 36, the heat is collected within and ultimately extracted from the second compartment 38. Specifically, in some embodiments, the airflow path AF enters through the first vent 54 and second vent 55, passes over a heat sink 60, and exits through the third vent 56. There is no fluid communication between the first compartment 36 and the second compartment 38, as described in further detail below. In other words, the first compartment 36 is completely sealed from the second compartment 38 and does not include any air vents, such that the airflow path AF is inhibited from passing over any specific electronic components (e.g., the terminal, microprocessor, battery cells, MOSFETS) of the circuit board 48.

With reference to Figs. 2-4, the heat sink 60 includes a mounting plate 64, a first portion or heat absorbing mass 68 projecting downward from the mounting plate 64 toward the circuit board 48, and a second portion or plurality of cooling fins 72 extending upward from the mounting plate 64 away from the circuit board 48. The mounting plate 64 receives fasteners 76 to mount the mounting plate 64 to the second housing portion 22 and engages a seal 80 disposed around the perimeter of the aperture 52. By tightening the fasteners 76, the mounting plate 64 compresses the seal 80 between the mounting plate 64 and the second housing portion 22 to fluidly seal the aperture 52, such that the second compartment 38 is not in fluid communication with the first compartment 36. Fluidly isolating the first compartment 36 from the second compartment 38 allows the battery pack 10 to fluidly dissipate heat from the electrical components (e.g., the battery cells 44, the circuit board 48) while minimizing inadvertent damage to the electrical components in cases where the battery pack 10 accidently comes in contact with liquid or other debris. The heat absorbing mass 68 projects through the aperture 52 of the second housing portion 22 and is disposed adjacent the heat generating electronic component 50. In other words, the heat absorbing mass 68 is disposed within the first compartment 36 of the first housing portion 18, while the mounting plate 64 and the plurality of cooling fins 72 are disposed within the second compartment 38 of the second housing portion 22. The seal 80 prevents ingress of liquid and debris from entering the first compartment 36. The tongue-and-groove joint 30 also prevents ingress of liquid and debris from entering the first compartment 36. In the illustrated embodiment, the heat absorbing mass 68 is indirectly contacting the heat generating electronic component 50 via a heat transfer medium 82 (Fig. 2) such as a thermal pad, paste, gel, plate, or composite, allowing for thermal conduction between the heat generating electronic component 50 and the heat sink 60. Accordingly, the heat transfer medium 82 is comprises a thermally conductive and electrically insulative material. In other embodiments, the heat transfer medium 82 may comprise an electrically conductive material and contact the heat generating electronic component 50 without causing a short circuit. In other embodiments, the heat absorbing mass 68 may alternatively be in direct contact with the heat generating electronic component 50 (e.g., MOSFETs, resistors, transistors, capacitors, inductors, sensors) of the circuit board 48. The heat sink 60 of the illustrated embodiment comprises aluminum or an aluminum alloy, while in other embodiments, the heat sink 60 comprises another material having heat conducting properties (e.g., copper, metallic alloys, composite alloys).

With continued reference to Figs. 2-4, the plurality of cooling fins 72 are disposed between the first mounting rail 32a and the second mounting rail 32b formed on the second housing portion 22 and below a cover 84 coupled to the second housing portion 22. The first vent 54 extends through the first mounting rail 32a and the second vent 55 extends through the second mounting rail 32b, such that the first vent 54 and the second vent 55are disposed on opposing sides of the heat sink 60, and more specifically, the plurality of cooling fins 72. In other words, the first vent 54 and the second vent 55 are disposed on opposite sides of the slide axis 33. The third vent 56 extends through the cover 84 and is located directly over the plurality of cooling fins 72. In other words, the plurality of cooling fins 72 are aligned with and extend toward the third vent 56. The heat sink 60 and the third vent 56 are aligned along an axis 74 that is perpendicular to the slide axis 33. The first and second mounting rails 32a, 32b also include a plurality of pockets 86 spaced apart from each other via a plurality of ribs 88. The ribs 88 increase the strength, rigidity, and wall thickness of the first and second mounting rails 32a, 32b. The plurality of pockets 86 are not vents because the plurality of pockets 86 do not extend entirely through the rails 32a, 32b, unlike the first and the second vents 54, 55.

The heat sink 60 is located adjacent the heat generating electronic component 50 of the circuit board 48, allowing the heat sink 60 to capture heat that is expelled during operation from the heat generating electronic component 50 and dissipate the heat away from the circuit board 48 to avoid inadvertent damage from overheating. Specifically, when the battery pack 10 is operating (e.g., when powering the electrical device or when being charged), the heat generating electronic component 50 generates heat that is then absorbed by the heat absorbing mass 68 of the heat sink 60. Subsequently, heat within the heat absorbing mass 68 conducts through the mounting plate 64 and the cooling fins 72. By natural convection, ambient air surrounding the housing 14 naturally enters the second compartment 38 via the first vent 54 and the second vent 55, and passes over the plurality of cooling fins 72. The ambient air naturally passing over the plurality of cooling fins 72 is heated and exits (i.e., rises) the second compartment 38 through the third vent 56, at which point ambient air is once again naturally pulled into the second compartment 38 through the first vent 54 and the second vent 55 where the process repeats.

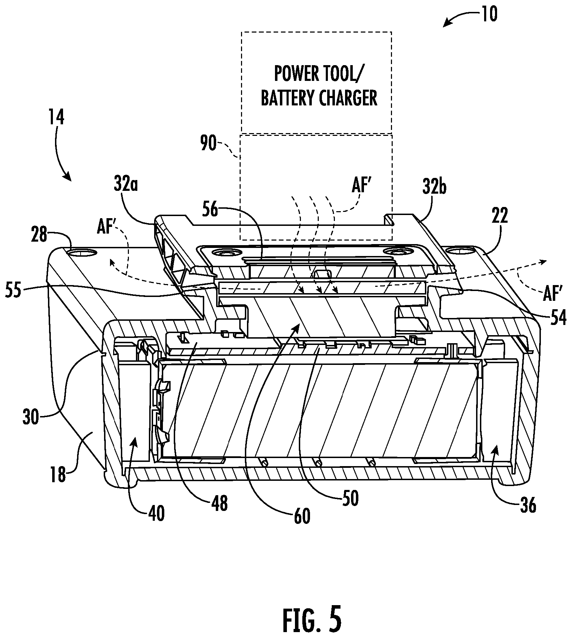

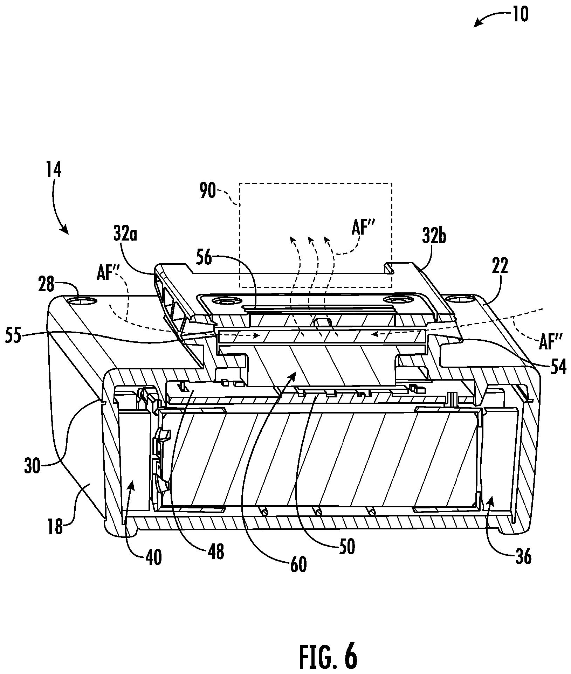

As shown in Figs. 5 and 6, an airflow source 90 may force convection over the plurality of cools fins 72 by pulling or pushing ambient air through the second compartment 38. In some embodiments, the airflow source 90 is a fan, motor, or impeller disposed within a device (e.g., a power tool, battery charger, vacuum cleaner) connected to the battery pack 10. Fig. 5 illustrates the airflow source 90 being disposed within a power tool or the battery charger and configured to create an airflow path AF' that pushes ambient air through the third vent 56, over the plurality of cooling fins 72, and exits through the first and second vents 54, 55. Fig. 6 illustrates the airflow source 90 being disposed adjacent to the third vent 56 and configured to create an airflow path AF" that pulls ambient air through the first and second vents 54, 55, over the plurality of cooling fins 72, and exits through the third vent 56.

The airflow source 90 may alternatively be coupled to or disposed within the housing 14 rather than disposed within a power tool or battery charger. In such a case, the airflow source 90 is powered by the plurality of battery cells 44 and may operate in a clockwise or counterclockwise direction to push the airflow path AF' or pull the airflow path AF" across the heat sink 60. In some embodiments, the airflow source 90 may be automatically activated in response to connecting the battery pack 10 to a power tool or the battery charger, for example, via a proximity switch, a limit switch, or some other sensor. The switch or sensor may be disposed on at least one of the first mounting rail 32a and the second mounting rail 32b, such that the switch or sensor is activated when the mounting rails 32a, 32b interface with a power tool or the battery pack. In any of the preceding embodiments, the airflow source 90 may be automatically activated in response to the battery pack 10 supplying power to a power tool or receiving power from the battery charger, for example, via a current sensor in a power circuit of the circuit board 48. Thus, when current is flowing through the power circuit of the circuit board 48 either to or from the plurality of battery cells 44, the current sensor is activated by detecting the flowing current.

Although aspects of the present disclosure have been described in detail with reference to certain embodiments, variations and modifications exist within the scope and spirit of one or more independent aspects as described. Various features and advantages are set forth in the following claims.

### CLAUSES

Clause 1. A battery pack for an electrical device, the battery pack comprising:
   a housing having a first housing portion defining a first compartment and a second housing portion defining a second compartment, the first housing portion adjacent the second housing portion;
   at least one terminal configured to electrically connect the battery pack to the electrical device;
   a plurality of battery cells disposed within the first compartment and configured to supply power to the electrical device;
   a circuit board disposed within the first compartment and including a heat generating component; and
   a heat sink coupled to the second housing portion and disposed adjacent the heat generating component, the heat sink including
      a first portion extending toward the heat generating component and disposed within the first compartment, and
      a second portion extending away from the heat generating component and disposed within the second compartment.
Clause 2. The battery pack of clause 1, wherein the first compartment is fluidly sealed from the second compartment, such that any fluid entering the first compartment is inhibited from entering the second compartment.
Clause 3. The battery pack according to any of the preceding clauses, wherein the second housing portion includes an aperture configured to receive the heat sink.
Clause 4. The battery pack of clause 3, further comprising a seal that is disposed around a perimeter of the aperture and configured to interface with a mounting plate of the heat sink to inhibit ingress of fluid and debris into the second compartment.
Clause 5. The battery pack of clause 4, wherein the mounting plate is coupled to the second housing portion and is configured to compress the seal between the mounting plate and the second housing portion.
Clause 6. The battery pack according to any of the preceding clauses, wherein the first portion of the heat sink is a heat absorbing mass configured to contact a thermal interface material disposed on the heat generating component.
Clause 7. The battery pack according to any of the preceding clauses, wherein the second portion of the heat sink includes a plurality of cooling fins that extend upward from the mounting plate.
Clause 8. The battery pack according to any of the preceding clauses, further comprising a first mounting rail and a second mounting rail disposed on the second housing portion and configured to couple the battery pack to the electrical device.
Clause 9. The battery pack of clause 8, wherein the heat sink is disposed between the first mounting rail and the second mounting rail.
Clause 10. The battery pack according to any one of clauses 8 or 9, wherein the first mounting rail includes a first vent and the second mounting rail includes a second vent, the first vent and the second vent are disposed on opposing sides of the second portion of the heat sink.
Clause 11. The battery pack according to any of the preceding clauses, further comprising a cover coupled to the second housing portion that encloses the second compartment, wherein the cover includes a third vent disposed adjacent to the second portion of the heat sink.
Clause 12. The battery pack of clause 11, wherein the first vent and the second vent allow an airflow path to enter the second compartment, wherein the airflow path flows over the second portion of the heat sink and exits through the third vent, thereby dissipating heat away from the heat sink and the circuit board.
Clause 13. The battery pack of clause 11, wherein the first vent, the second vent, and the third vent allow heat dissipated by the heat sink to exit the second compartment, wherein the heat dissipates from the second portion of the heat sink, thereby drawing heat away from the heat generating component.
Clause 14. The battery pack according to any of the preceding clauses, wherein the circuit board is situated atop the plurality of battery cells.
Clause 15. A battery pack for an electrical device, the battery pack comprising:
   a housing having a first housing portion defining a first compartment and a second housing portion defining a second compartment, the first housing portion adjacent the second housing portion;
   a plurality of battery cells disposed within the first compartment and configured to supply power to the electrical device;
   a circuit board disposed within the first compartment and including a heat generating component aligned with an aperture in the second housing portion;
   a heat sink coupled to the second housing portion and covering the aperture, resulting in the second compartment being fluidly sealed from the first compartment;
   a first vent disposed on the second housing portion that allows ambient air surrounding the housing to enter the second compartment, creating an airflow path within the second compartment; and
   another vent in fluid communication with the second compartment configured to allow the airflow path to exit the second compartment after passing over the heat sink.
Clause 16. The battery pack of clause 15, wherein the first vent extends through a first mounting rail of the second housing portion, wherein the battery pack further includes a second vent that extends through a second mounting rail of the second housing portion, wherein the first mounting rail and the second mounting rail are configured to couple the battery pack to the electrical device.
Clause 17. The battery pack according to any of the preceding clauses, wherein the another vent is a third vent that is disposed adjacent to the heat sink and is aligned with a plurality of cooling fins extending upward from the heat sink.
Clause 18. The battery pack according to any of the preceding clauses, further comprising a seal that is disposed around a perimeter of the aperture and configured to interface with the heat sink to inhibit ingress of fluid and debris into the second compartment.
Clause 19. The battery pack of clause 18, wherein the heat sink is coupled to the second housing portion and is configured to compress the seal between the heat sink and the second housing portion.
Clause 20. The battery pack according to any of the preceding clauses, where the heat sink includes a first portion that extends through the aperture and is configured to contact a thermal interface material disposed on the heat generating component of the circuit board, such that the first portion is disposed within the first compartment.
Clause 21. The battery pack according to any of the preceding clauses, wherein the heat sink includes a second portion that is disposed within the second compartment.
Clause 22. The battery pack of clause 21, wherein the second portion of the heat sink is disposed between the first vent and the second vent.
Clause 23. The battery pack according to any of the preceding clauses, wherein the third vent extends through a cover coupled to the second housing portion, wherein the cover encloses the second compartment.
Clause 24. The battery pack according to any of the preceding clauses, further comprising at least one terminal configured to electrically connect the battery pack to the electrical device.
Clause 25. The battery pack according to any of the preceding clauses, wherein the circuit board is situated atop the plurality of battery cells.
Clause 26. A battery pack for an electrical device, the battery pack comprising:
   a housing having a first compartment and a second compartment that is fluidly sealed from the first compartment;
   a plurality of battery cells disposed within the first compartment and configured to supply power to the electrical device;
   a circuit board disposed within the first compartment and including a heat generating component; and
   a heat sink coupled to the housing and is in direct contact with the heat generating component to dissipate heat away from the second compartment.
Clause 27. The battery pack of clause 26, wherein the housing includes an aperture that receives the heat sink.
Clause 28. The battery pack of clause 27, further comprising a seal that is disposed around a perimeter of the aperture and configured to interface with a mounting plate of the heat sink to inhibit ingress of fluid and debris into the second compartment.
Clause 29. The battery pack according to any of the preceding clauses, wherein the heat sink includes a heat absorbing mass that is configured to contact a thermal interface material disposed on the heat generating component and disposed within the first compartment.
Clause 30. The battery pack according to any of the preceding clauses, wherein the heat sink includes a plurality of cooling fins that extend away from the heat generating component and disposed within the second compartment.
Clause 31. The battery pack of clause 30, further comprising a first mounting rail and a second mounting rail that are disposed on the housing and configured to couple the battery pack to the electrical device, wherein the plurality of cooling fins is disposed between the first mounting rail and the second mounting rail.
Clause 32. The battery pack of clause 31, wherein the first mounting rail includes a first vent and the second mounting rail includes a second vent, the first vent and the second vent are disposed adjacent the plurality of cooling fins.
Clause 33. The battery pack of clause 32, further comprising a third vent that extends through a cover coupled to the housing, wherein the third vent is disposed directly over the plurality of cooling fins.
Clause 34. The battery pack of clause 33, wherein the first vent and the second vent allow an airflow path to enter the first compartment, at which point the airflow path flows over the plurality of cooling fins and exits through the third vent, thereby dissipating heat away from the heat sink and the circuit board.
Clause 35. The battery pack of clause 33, wherein the first vent, the second vent, and the third vent allow heat dissipated by the heat sink to exit the second compartment, wherein the heat dissipates from the plurality of cooling fins, thereby drawing heat away from the heat generating component.
Clause 36. The battery pack according to any of the preceding clauses, further comprising at least one terminal configured to electrically connect the battery pack to the electrical device.
Clause 37. The battery pack according to any of the preceding clauses, wherein the circuit board is situated atop the plurality of battery cells.
Clause 38. A battery pack for an electrical device, the battery pack comprising:
   a housing;
   a plurality of battery cells disposed within the housing and configured to supply power to the electrical device, the plurality of battery cells are fluidly sealed from an environment surrounding the housing;
   a circuit board coupled to the plurality of battery cells and including a heat generating component; and
   a heat sink coupled to the housing and disposed adjacent to the heat generating component to dissipate heat away from the plurality of battery cells to the environment.
Clause 39. The battery pack of clause 38, wherein the housing includes an aperture that receives the heat sink.
Clause 40. The battery pack of clause 39, further comprising a seal that is disposed around a perimeter of the aperture and configured to interface with a mounting plate of the heat sink to inhibit ingress of fluid and debris from the environment into the housing.
Clause 41. The battery pack according to any of the preceding clauses, wherein the heat sink includes a heat absorbing mass that is configured to contact a thermal interface material disposed on the heat generating component, the heat absorbing mass is disposed within the housing.
Clause 42. The battery pack according to any of the preceding clauses, wherein the heat sink includes a plurality of cooling fins that extend in a direction away from the heat generating component.
Clause 43. The battery pack of clause 42, further comprising a first mounting rail and a second mounting rail that are disposed on the housing and configured to couple the battery pack to the electrical device, wherein the plurality of cooling fins is disposed between the first mounting rail and the second mounting rail.
Clause 44. The battery pack of clause 43, wherein the first mounting rail includes a first vent and the second mounting rail includes a second vent, the first vent and the second vent are disposed adjacent the plurality of cooling fins.
Clause 45. The battery pack of clause 44, further comprising a third vent that extends through a cover coupled to the housing, wherein the third vent and the heat sink are aligned along an axis that is perpendicular to a slide axis of the battery pack.
Clause 46. The battery pack of clause 45, wherein the first vent and the second vent allow an airflow path to flow through the plurality of cooling fins and exit through the third vent, thereby dissipating heat away from the heat sink and the circuit board.
Clause 47. The battery pack of clause 45, wherein the first vent, the second vent, and the third vent allow heat dissipated by the heat sink to exit the housing, wherein the heat dissipates from the plurality of cooling fins, thereby drawing heat away from the heat generating component.
Clause 48. The battery pack of clause 38, wherein the housing includes a first compartment and a second compartment that is fluidly sealed from the first compartment, and wherein the plurality of battery cells and the circuit board are both disposed within the first compartment.
Clause 49. The battery pack according to any of the preceding clauses, further comprising at least one terminal configured to electrically connect the battery pack to the electrical device.
Clause 50. The battery pack according to any of the preceding clauses, wherein the circuit board is situated atop the plurality of battery cells.

## Claims

1. A battery pack for an electrical device, the battery pack comprising:
a housing having a first housing portion defining a first compartment and a second housing portion defining a second compartment, the first housing portion adjacent the second housing portion;
at least one terminal configured to electrically connect the battery pack to the electrical device;
a plurality of battery cells disposed within the first compartment and configured to supply power to the electrical device;
a circuit board disposed within the first compartment and including a heat generating component; and
a heat sink coupled to the second housing portion and disposed adjacent the heat generating component, the heat sink including
a first portion extending toward the heat generating component and disposed within the first compartment, and
a second portion extending away from the heat generating component and disposed within the second compartment.

2. The battery pack of claim 1, wherein the first compartment is fluidly sealed from the second compartment, such that any fluid entering the first compartment is inhibited from entering the second compartment.

3. The battery pack according to any of the preceding claims, wherein the second housing portion includes an aperture configured to receive the heat sink.

4. The battery pack of claim 3, further comprising a seal that is disposed around a perimeter of the aperture and configured to interface with a mounting plate of the heat sink to inhibit ingress of fluid and debris into the second compartment.

5. The battery pack of claim 4, wherein the mounting plate is coupled to the second housing portion and is configured to compress the seal between the mounting plate and the second housing portion.

6. The battery pack according to any of the preceding claims, wherein the first portion of the heat sink is a heat absorbing mass configured to contact a thermal interface material disposed on the heat generating component.

7. The battery pack according to any of the preceding claims, wherein the second portion of the heat sink includes a plurality of cooling fins that extend upward from the mounting plate.

8. The battery pack according to any of the preceding claims, further comprising a first mounting rail and a second mounting rail disposed on the second housing portion and configured to couple the battery pack to the electrical device.

9. The battery pack of claim 8, wherein the heat sink is disposed between the first mounting rail and the second mounting rail.

10. The battery pack according to any one of claims 8 or 9, wherein the first mounting rail includes a first vent and the second mounting rail includes a second vent, the first vent and the second vent are disposed on opposing sides of the second portion of the heat sink.

11. The battery pack according to any of the preceding claims, further comprising a cover coupled to the second housing portion that encloses the second compartment, wherein the cover includes a third vent disposed adjacent to the second portion of the heat sink.

12. The battery pack of claim 11, wherein the first vent and the second vent allow an airflow path to enter the second compartment, wherein the airflow path flows over the second portion of the heat sink and exits through the third vent, thereby dissipating heat away from the heat sink and the circuit board.

13. The battery pack of claim 11, wherein the first vent, the second vent, and the third vent allow heat dissipated by the heat sink to exit the second compartment, wherein the heat dissipates from the second portion of the heat sink, thereby drawing heat away from the heat generating component.

14. The battery pack according to any of the preceding claims, wherein the circuit board is situated atop the plurality of battery cells.
